# EUROPÄISCHE PATENTSCHRIFT

(11) **EP 4 115 189 B1**
(45) Veröffentlichungstag und Bekanntmachung des Hinweises auf die Patenterteilung: **02.09.2026**
(21) Anmeldenummer: 21708922.6
(22) Anmeldetag: 18.02.2021
(51) Int. Cl.: G01R 1/20, G01R 15/20, G01R 31/364

(54) **STROMSENSOR**
CURRENT SENSOR
CAPTEUR DE COURANT

(30) Priorität: 03.03.2020 DE 102020202694
(43) Veröffentlichungstag der Anmeldung: 11.01.2023
(73) Patentinhaber: AUMOVIO Germany GmbH, 60488 Frankfurt am Main (DE)
(72) Erfinder: IRSIGLER, Michael, 60488 Frankfurt am Main (DE); BÖHM, Matthias, 60488 Frankfurt am Main (DE); GROBE, Dirk, 60488 Frankfurt am Main (DE); RAO, Sudarshan, 60488 Frankfurt am Main (DE)
(74) Vertreter: Aumovio Corporation
(86) Internationale Anmeldenummer: PCT/DE2021/200018
(87) Internationale Veröffentlichungsnummer: WO 2021/175382

(56) Entgegenhaltungen:
- WO-A1-2007/068221
- WO-A1-2013/007833
- DE-A1- 102016 218 049
- US-A1- 2017 261 536

## Beschreibung

Die Entwicklung betrifft einen Stromsensor zur Strommessung in einem Fahrzeug mit zwei unabhängigen Messprinzipien.

In Fahrzeugen, insbesondere bei Elektrofahrzeugen oder Hybridfahrzeugen, werden Batterien mit hohen Spannungen verwendet. Im Betrieb des Fahrzeugs ist es erforderlich, die Batterieströme permanent zu erfassen, um genaue Aussagen über den Ladezustand der Fahrzeug Batterie treffen zu können.

Um die im Automobilbereich geforderte Ausfallsicherheit zu gewährleisten und die geforderte Genauigkeit der Strommessung sicherzustellen, ist es erforderlich, eine redundante Strommessung bereitzustellen, insbesondere mit zwei voneinander unabhängigen Sensoren und/oder Messprinzipien. Solche Sensoren sind beispielsweise in der EP2732295A1, der US 2017/261536 A1, der WO 2007/068221 A1, der DE 102016 218 049 A1 oder der WO 2013/007833 A1 gezeigt.

Aufgabe der Erfindung ist es, einen vorstehend beschriebenen Sensor zu verbessern, indem die Messgenauigkeit sowie die Ausfallsicherheit erhöht werden.

Zur Lösung der Aufgabe ist ein Batteriesensor zur Erfassung eines durch einen elektrischen Leiter fließenden Stroms vorgesehen, wobei der Batteriesensor zumindest zwei voneinander unabhängige Messeinrichtungen zur Erfassung des durch den elektrischen Leiter fließenden Stroms aufweist. Die Messeinrichtungen sind konstruktiv und elektrisch vollständig voneinander getrennt. Jede Messeinrichtung ist auf einer separaten Leiterplatte angeordnet. Durch die vollständige Trennung der Messeinrichtungen ist zuverlässig sichergestellt, dass sich diese nicht gegenseitig beeinflussen. Das heißt die Messeinrichtungen nutzen keine gemeinsamen Bauteile, sodass Einflüsse eines Bauteils sich nicht auf die jeweils andere Messeinrichtung auswirken. Insbesondere können auch Leiterplatten mit einem anderen Aufbau verwendet werden, sodass konstruktive Nachteile einer bestimmten Leiterplatte nur in einer der beiden Messeinrichtungen auftreten können. insbesondere können die Leiterplatten getrennt hergestellt werden, sodass sich Fehler in der Produktion nicht auf beide Messeinrichtungen auswirken können.

Um die Messeinrichtungen vollständig unabhängig voneinander zu machen, ist für jede Messeinrichtung eine separate Stromversorgung vorgesehen. Fehler in einer der Stromversorgungen wirken sich somit nicht auf die jeweils andere Messeinrichtung aus.

Zumindest eine Messeinrichtung funktioniert nach einem magnetischen Messprinzip. Es können aber auch andere magnetische Messprinzipien verwendet werden, die eine Änderungen des Magnetfeldes aufgrund des durch den Leiter fließenden Stromes erfassen.

Zumindest eine Messeinrichtung weist zumindest einen Messwiderstand sowie eine Spannungserfassungseinrichtung zur Erfassung der über den Messwiderstand abfallenden Spannung auf. Aus der gemessenen Spannungsdifferenz sowie dem bekannten elektrischen Widerstand des Messwiderstandes kann über das ohmsche Gesetz der über den Messwiderstand fließende Strom berechnet werden.

Des Weiteren weist jede Messeinrichtung einen separaten Signaleingang und Signalausgang auf. Das heißt es erfolgt keine gemeinsame Signalverarbeitung oder Auswertung innerhalb des Batteriesensor.

Insbesondere sind die Messeinrichtung gegeneinander elektrisch isoliert, um eine gegenseitige Beeinflussung zuverlässig auszuschließen. Beispielsweise sind die Messeinrichtungen galvanisch voneinander getrennt bzw. galvanisch entkoppelt Die nach einem magnetischen Messprinzip funktionierende Messeinrichtung weist vorzugsweise einen Hallsensor auf.

Diese Messeinrichtung ist vorzugsweise zur Spannungserfassung vor und hinter dem Messwiderstand mit dem elektrischen Leiter kontaktiert. Um einen Spannungsüberschlag innerhalb dieser Messeinrichtung von dem elektrischen Leiter auf den Signalausgang bzw. den Signaleingang und oder die Stromversorgung zu vermeiden, sind vorzugsweise Vorrichtungen zur elektrischen Trennung der Messeinrichtung von den Signaleingängen bzw. Signalausgängen sowie einem Anschluss für die Stromversorgung vorgesehen.

Beispielsweise weisen diese Vorrichtungen zumindest einen Transformator aufweisen. Insbesondere kann ein solcher Transformator platzsparend innerhalb der Leiterplatte angeordnet sein.

In einer nicht beanspruchten Ausführungsform können auch zwei Messeinrichtungen mit dem gleichen Messprinzip verwendet werden, beispielsweise mit einem Messwiderstand oder einem magnetischen Messprinzip. Es ist lediglich darauf zu achten, dass die Messeinrichtungen vollständig unabhängig voneinander sind, um Beeinflussungen durch einen gemeinsamen Störfaktor auszuschließen oder zumindest zu reduzieren. Es ist aber möglich, dass beide Messeinrichtungen denselben Messwiderstand nutzen, solange die Erfassung der Spannungsabfälle sowie die Signalverarbeitung vollständig unabhängig voneinander ist und eine gemeinsame Beeinflussung beider Messungen durch einen Störfaktor ausgeschlossen ist.

Weitere Vorteile und Merkmale finden sich in der nachfolgenden Beschreibung in Verbindung mit den beigefügten Zeichnungen. In diesem zeigen:
- Figur 1: eine schematische Darstellung eines Batteriesensors;

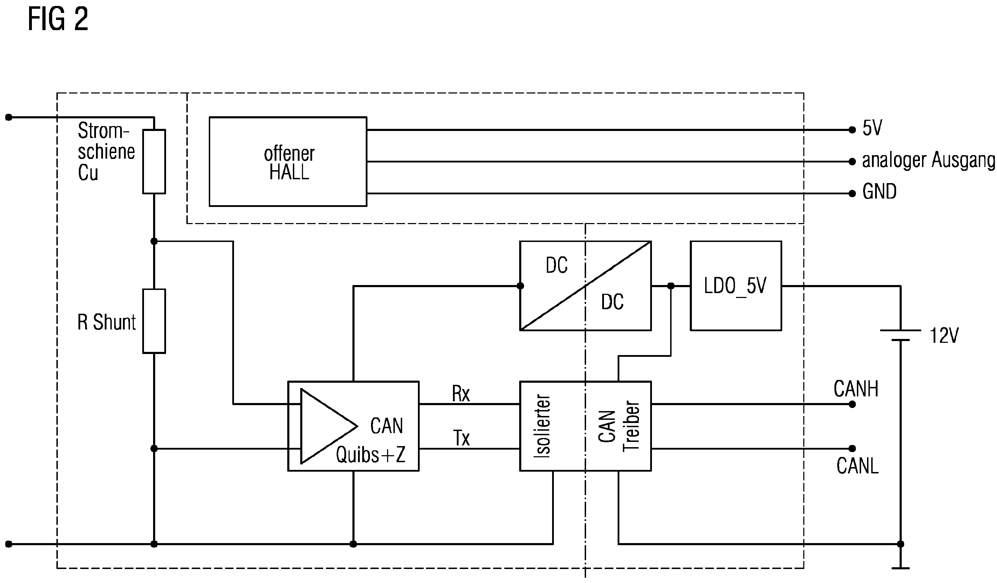

- Figur 2: eine zweite schematische Darstellung eines Batteriesensors;
- Figur 3: eine perspektivische Ansicht eines Batteriesensors.

Der Stromsensor hat einen elektrischen Leiter (Bus bar 800V), der im Hochvolt-Stromkreis angeordnet ist und somit vom Batteriestrom durchflossen wird. Der Stromsensor wird vorzugsweise in Fahrzeugen mit Elektroantrieb oder Hybridantrieb eingesetzt, um die von der Fahrzeugbatterie bereitgestellten oder die beim Ladebetrieb anliegenden hohen Ströme zu messen.

An einem ersten Abschnitt des elektrischen Leiters ist eine erste Messeinrichtung vorgesehen, bei der eine kontaktlose Strommessung über ein magnetisches Messprinzip mit einem Hallsensor (contactless ASIC bzw. open loop HALL) erfolgt. Die Stromversorgung des Hallsensors erfolgt über einen Niedervolt-Stromkreis mit 5V (Power Supply 2), beispielsweise durch eine Fahrzeugbatterie (12V). Des Weiteren weist der Hallsensor einen Signalausgang (Analog Out) zur Ausgabe der Messwerte auf. Der Hallsensor selbst ist nicht mit dem elektrischen Leiter verbunden und weist somit keine elektrische Kontaktierung zur Hochvoltseite (HV) auf. Der Hallsensor befindet sich also vollständig auf der Niedervolt-Seite (NV). An einem zweiten Abschnitt ist eine zweite Messeinrichtung vorgesehen, mit einem Messwiderstand (Shunt) sowie einer Messvorrichtung (Shunt Quibz + Z), die jeweils vor und nach dem Messwiderstand mit dem elektrischen Leiter kontaktiert ist. Die Messvorrichtung kann die Spannung vor und nach dem Messwiderstand und somit den Spannungsabfall über den Messwiderstand messen. Aus der Spannungsdifferenz sowie dem bekannten elektrischen Widerstand des Messwiderstandes kann über das ohmsche Gesetz der über den Messwiderstand fließende Strom berechnet werden.

Die zweite Messvorrichtung hat ebenfalls ein Niedervolt-Stromanschluss mit 5 V bzw. 12 V (Power Supply 1) sowie einen Signalausgang (CAN out) zur Ausgabe der Messwerte.

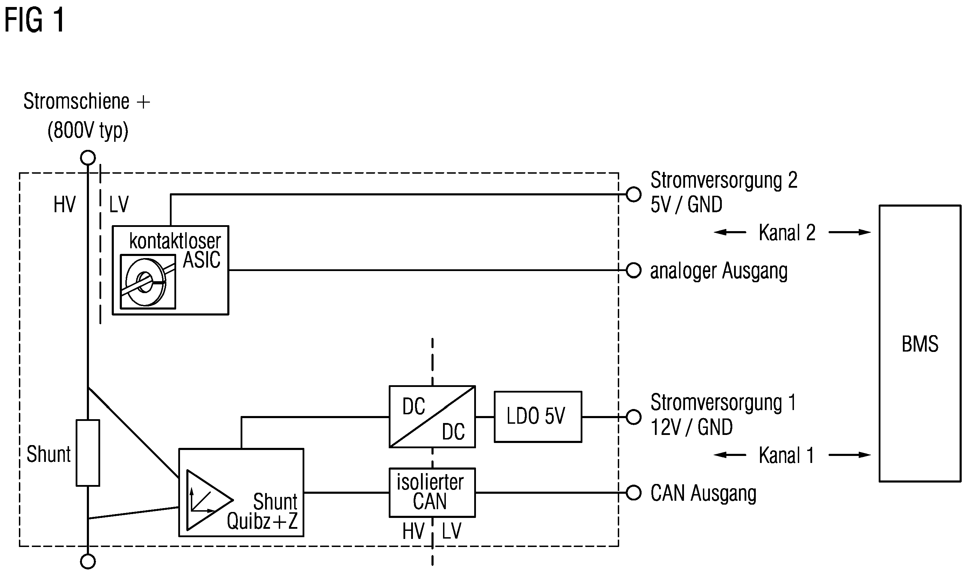

Wie insbesondere in Figur 1 zu sehen ist, ist die zweite Messeinrichtung über die Anschlüsse vor und nach dem Messwiderstand mit dem Hochvolt-Stromkreis verbunden. Die Trennung zwischen Hochvolt-Seite und Niedervolt Seite erfolgt hier in der Stromversorgung (DC/DV) bzw. in dem den entsprechend isolierten Signalausgang (Isolated CAN-Driver). Auf der Leiterplatte der zweiten Messeinrichtung ist beispielsweise sowohl für die Stromversorgung wie auch für den Signalausgang eine Trennung über einen Transformator vorgesehen, durch den die Hochvolt-Seite und die Niedervolt-Seite voneinander getrennt sind.

Alternativ können auch andere Vorrichtungen der konstruktive Maßnahmen vorgesehen sein, die eine Signalübertragung bzw. eine Stromversorgung ermöglichen aber einen Spannung über zuverlässig ausschließen.

Um sicherzustellen, dass der Hallsensor und die Shuntmessung vollständig unabhängig voneinander sind, sind diese an verschiedenen Abschnitten des elektrischen Leiters angeordnet.

Des Weiteren erfolgt die Stromversorgung beider Messeinrichtungen unabhängig voneinander, d. h. Fehler innerhalb der Stromversorgung wirken sich nur auf die jeweilige Messeinrichtung aus und nicht auf beide Messeinrichtungen.

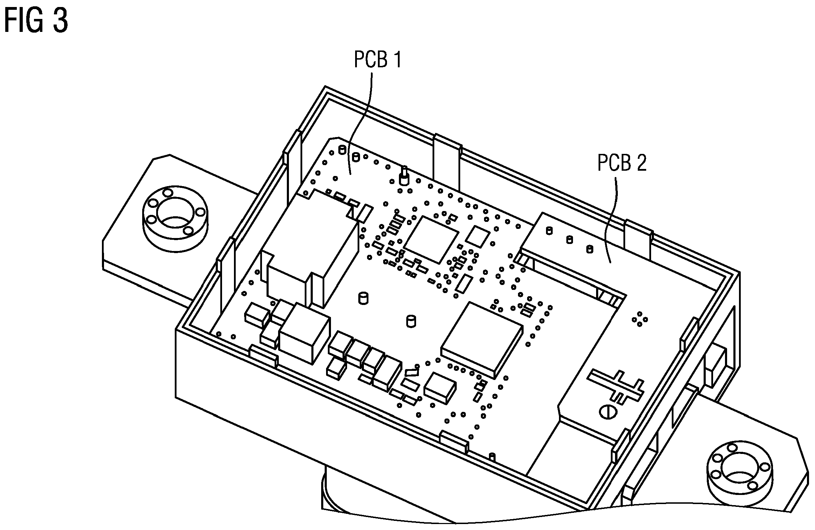

Darüber hinaus sind, wie in Figur 3 zu sehen ist, für beide Messeinrichtungen separate Leiterplatten (PCB1, PCB2) vorgesehen. Dadurch ist sichergestellt, dass die Messeinrichtungen vollständig voneinander getrennt sind und sich nicht gegenseitig beeinflussen können. Insbesondere können die Messeinrichtung räumlich beliebig zueinander positioniert werden. Zudem können beispielsweise verschiedene Leiterplatten gewählt werden, um beispielsweise Produktionseinflüsse zu minimieren.

Zusätzlich können konstruktive Maßnahmen zur Trennung der der Leiterplatten vorgesehen sein, um jegliche gegenseitige Entlassung auszuschließen. Beispielsweise kann eine galvanische Trennung bzw. Entkoppelung vorgesehen sein.

## Patentansprüche

1. Batteriesensor zur Erfassung eines durch einen elektrischen Leiter fließenden Stroms, wobei der Batteriesensor zumindest zwei voneinander unabhängige Messeinrichtungen zur Erfassung des durch den elektrischen Leiter fließenden Stroms aufweist, wobei die Messeinrichtungen konstruktiv und elektrisch vollständig voneinander getrennt sind, wobei jede Messeinrichtung auf einer separaten Leiterplatte angeordnet ist, wobei zumindest eine Messeinrichtung nach einem magnetischen Messprinzip funktioniert, und
zumindest eine Messeinrichtung zumindest einen Messwiderstand aufweist sowie eine Spannungserfassungseinrichtung zur Erfassung der über den Messwiderstand abfallenden Spannung, und
für jede Messeinrichtung eine separate Stromversorgung vorgesehen ist, und jede Messeinrichtung einen separaten Signaleingang und Signalausgang aufweist.

2. Batteriesensor nach Anspruch 1, **dadurch gekennzeichnet, dass** die Messeinrichtungen gegeneinander isoliert sind

3. Batteriesensor nach einem der vorhergehenden Ansprüche, **dadurch gekennzeichnet, dass** die nach einem magnetischen Messprinzip funktionierende Messeinrichtung einen Hallsensor aufweist.

4. Batteriesensor nach einem der vorhergehenden Ansprüche, **dadurch gekennzeichnet, dass** in der den Messwiderstand aufweisenden Messeinrichtung Vorrichtungen zur elektrischen Trennung der Messeinrichtung von den Signaleingängen bzw. Signalausgängen sowie einem Anschluss für die Stromversorgung vorgesehen sind.

5. Batteriesensor nach Anspruch 4, **dadurch gekennzeichnet, dass** die Vorrichtungen zumindest einen Transformator aufweisen können.

## Claims

1. A battery sensor for detecting a current flowing through an electrical conductor, wherein the battery sensor has at least two mutually independent measuring apparatuses for detecting the current flowing through the electrical conductor, wherein the measuring apparatuses are structurally and electrically completely separated from one another, wherein each measuring apparatus is arranged on a separate printed circuit board, wherein at least one measuring apparatus functions according to a magnetic measuring principle, and
at least one measuring apparatus has at least one measuring resistor as well as a voltage detection apparatus for detecting the voltage dropping across the measuring resistor, and
a separate power supply is provided for each measuring apparatus, and each measuring apparatus has a separate signal input and signal output.

2. The battery sensor according to claim 1, **characterised in that** the measuring apparatuses are insulated from one another.

3. The battery sensor according to any one of the preceding claims, **characterised in that** the measuring apparatus functioning according to a magnetic measuring principle has a Hall sensor.

4. The battery sensor according to any one of the preceding claims, **characterised in that** devices for electrical separation of the measuring apparatus from the signal inputs or signal outputs as well as a connection for the power supply are provided in the measuring apparatus having the measuring resistor.

5. The battery sensor according to claim 4, **characterised in that** the devices can have at least one transformer.

## Revendications

1. Capteur de batterie destiné à la détection d'un courant circulant à travers un conducteur électrique, dans lequel le capteur de batterie présente au moins deux dispositifs de mesure indépendants l'un de l'autre pour la détection du courant circulant à travers le conducteur électrique, dans lequel les dispositifs de mesure sont séparés l'un de l'autre de manière complète tant sur le plan constructif que sur le plan électrique, dans lequel chaque dispositif de mesure est disposé sur une carte de circuit imprimé distincte, dans lequel au moins un dispositif de mesure fonctionne selon un principe de mesure magnétique, et
au moins un dispositif de mesure présente au moins une résistance de mesure ainsi qu'un dispositif de détection de la tension destiné à détecter la tension chutant aux bornes de la résistance de mesure, et
une alimentation électrique distincte est prévue pour chaque dispositif de mesure, et chaque dispositif de mesure présente une entrée de signal distincte et une sortie de signal distinctes.

2. Capteur de batterie selon la revendication 1, **caractérisé en ce que** les dispositifs de mesure sont isolés les uns des autres.

3. Capteur de batterie selon l'une quelconque des revendications précédentes, **caractérisé en ce que** le dispositif de mesure fonctionnant selon un principe de mesure magnétique présente un capteur à effet Hall.

4. Capteur de batterie selon l'une quelconque des revendications précédentes, **caractérisé en ce que**, dans le dispositif de mesure présentant la résistance de mesure, sont prévus des dispositifs destinés à assurer la séparation électrique du dispositif de mesure par rapport aux entrées de signal et/ou aux sorties de signal ainsi qu'à un raccordement pour l'alimentation électrique.

5. Capteur de batterie selon la revendication 4, **caractérisé en ce que** les dispositifs peuvent présenter au moins un transformateur.
